(19) Europäisches Patentamt
European Patent Office
Office européen des brevets

(11) EP 4 703 738 A1

(12) EUROPEAN PATENT APPLICATION

(43) Date of publication:
04.03.2026 Bulletin 2026/10

(21) Application number: 24197328.8

(22) Date of filing: 29.08.2024

(51) International Patent Classification (IPC):
$G01R\ 29/08\ ^{(2006.01)}$

(52) Cooperative Patent Classification (CPC):
G01R 29/0885; H04B 2210/006

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: British Telecommunications Public
Limited Company
London E1 8EE (GB)

(72) Inventors:
• SUN, Qiushuo
London, E1 8EE (GB)
• SINGH, Alok
London, E1 8EE (GB)
• GILKS, Daniel
London, E1 8EE (GB)

(74) Representative: British Telecommunications
public limited company
Intellectual Property Department
9th Floor
One Braham
Braham Street
London E1 8EE (GB)

(54) **ELECTROMAGNETIC FIELD DETECTOR**

(57) An apparatus (100) for detecting an Electro-Magnetic, EM, field, said apparatus comprising a: Rydberg-Atom EM Field Detector (107), RAEM-FD, configured to detect an EM field (170) from a source (175); and a plurality of waveguides (105) for the RAEM-FD, wherein each of the plurality of waveguides is: configured to permit propagation of the EM field therethrough to the RAEM-FD; arranged around the RAEM-FD; and orientated towards a different direction.

Figure 1

## Description

Field of Invention

The present invention relates to an apparatus for detecting an Electro-Magnetic, EM, field, comprising a Rydberg-Atom EM Field Detector, a RAEM-FD, and a plurality of waveguides.

Background

In wireless telecommunications, a transmitted wireless signal will decrease in signal strength with distance from a transmission source (e.g. due to scattering, reflection and propagation losses). Beyond a sensitivity threshold of a wireless receiver, the wireless signal cannot be detected above a background noise level at the receiver. As a result, extrinsic background noise, or the noise floor of the receiving apparatus dominates.

The detection threshold of a wireless receiver places undesirable constraints upon effective wireless telecommunications, and in particular upon range, capacity, and energy-efficiency of the physical layer of radio-based communication.

It is an aim of the present invention to alleviate at least some of the aforementioned problems.

Statements of Invention

According to an aspect of the invention, there is provided an apparatus for detecting an Electro-Magnetic, EM, field, said apparatus comprising a: Rydberg-Atom EM Field Detector, RAEM-FD, configured to detect an EM field from a source; and plurality of waveguides for the RAEM-FD, wherein each of the plurality of waveguides is: configured to permit propagation of the EM field therethrough to the RAEM-FD; arranged around the RAEM-FD; and orientated towards a different direction.

Preferably, each of the plurality of waveguides is arranged towards a different bearing relative to the RAEM-FD. Preferably, each of the plurality of waveguides comprises an: input end for receiving the EM field into the corresponding waveguide and output end for outputting the received EM field from the corresponding waveguide; and wherein each input end is orientated towards said different direction and/or bearing. Preferably, each of the plurality of waveguides (and, more preferably, a corresponding input end) is outward facing, that is, away from (and not towards) the RAEM-FD. Preferably, the RAEM-FD is configured to detect the EM field by exploiting Electromagnetically Induced Transparency. Preferably, the RAEM-FD comprises a/an: container (e.g. a vapour cell) comprising a medium of Rydberg atoms; probe laser configured to transmit a probe signal through the vapour cell; coupling laser configured to transmit a coupling signal into the vapour cell and in counter propagation to the probe signal; and a photodetector configured to receive the probe signal having been transmitted through the vapour cell. Preferably, the medium of Rydberg atoms comprises or consists of an alkali or alkali earth metal, and more preferably Rubidium or Caesium. Optionally, at least one, or all, of the waveguides consist/s of a vacuum or a dielectric medium arranged therebetween (at least within a corresponding overlapping region), and the dielectric medium may be a gas and/or liquid, and may be air or water. As used herein, the term "therethrough", used with reference to the plurality of waveguides and propagation of the EM field, preferably connotes propagation through, into, out of, and/or within the waveguide.

Preferably, at least two, none, or all, of the plurality of waveguides are different. Optionally, said plurality of waveguides (optionally, more specifically the input and/or output end/s) are different (or identical) as to: dimensions; shape and/or geometry; location (e.g. distance relative to the RAEM-FD); cut-off frequency; focal length; type or form (e.g. horn or parallel plate waveguide); construction; material composition; and/or lensing effect.

Preferably, at least three, or all, of the plurality of waveguides are arranged in the same plane. Preferably, said plurality of waveguides are also arranged in the same plane as the RAEM-FD. Optionally, some, but not all, of the plurality of waveguides are arranged in the same plane. Optionally, at least an adjacent pair of the plurality of waveguides are offset by 180°, more preferably by 90°, and still more preferably by 45°.

Preferably, the plurality of waveguides comprises at least one of a: Parallel-Plate WaveGuide, PPWG; Multi-Plate WaveGuide, MPWG; Tapered Parallel-Plate WaveGuide, TPPWG; horn; and/or lens. Optionally, the lens is configured to cause a, convergent or divergent, lensing effect upon the EM field. Optionally, the MPWG comprises: at least three overlapping and non-intersecting plates; and at least two sub-waveguides, each formed by an adjacent pair of the at least three plates, and wherein each waveguide has a separation distance suitable for supporting propagation of the EM field. Optionally, the MPWG is configured as a convergent or divergent lens. Optionally, the RAEM-FD, and more preferably specifically the constituent vapour cell, is: arranged in the same plane as the, or each, waveguide; and/or located outside of, or within, at least one of said waveguide/s.

Preferably, the apparatus further comprises a re-orientation mechanism engaged to the plurality of waveguides and configured to revolve said plurality of waveguides about the RAEM-FD. Optionally, the re-orientation mechanism comprises a plurality of independent re-orientation mechanisms for independently re-orientating at least one of said waveguides.

Preferably, the re-orientation mechanism is operated so as to align at least one of the plurality of waveguides between the source and the RAEM-FD. Optionally, the re-orientation mechanism is configured orbitally (*i.e.* circularly or elliptically) to move the plurality of waveguides around the RAEM-FD, and more preferably about an axis that intercepts any portion of the RAEM-FD, and more preferably that intercepts the vapour cell, and still more preferably that intercepts a centre thereof. In this way, the plurality of waveguides may be reorientated so as to align the plurality of waveguides between different sources of the, or another, EM field and the RAEM-FD.

Optionally, the re-orientation mechanism is configured to revolve the plurality of waveguides in a circular (or elliptical) or spherical (or ellipsoidal) motion (e.g. by comprising a one- or two-axis gimbal) around the RAEM-FD (which may optionally be located at a centre of said motion). Optionally, the reorientation mechanism comprises a motor, gear mechanism, spinning disk, carrousel, belt drive, cam, wheel, conveyer, and/or actuator. Optionally, the reorientation mechanism is manually operated, rather than motorised. Optionally, the reorientation mechanism is further engaged to the RAEM-FD, thereby also to impart rotation to the RAEM-FD. Optionally, the re-orientation mechanism is mutually coupled to both the RAEM-FD and the plurality of waveguides so as to impart corresponding motion upon each. Preferably, the re-orientation mechanism comprises a rotator for spinning the RAEM-FD.

Preferably, the apparatus further comprises a controller configured to: tune the RAEM-FD so as to detect the EM field; measure the EM field, as detected by the RAEM-FD; and control operation of the re-orientation mechanism so as to move one of the plurality of waveguides into alignment between the source and the RAEM-FD. Preferably, the controller is configured to tune the RAEM-FD by reconfiguring the coupling and/or probe laser/s to change a frequency of the coupling and/or probe signal/s so as to induce an atomic transition in the vapour cell that permits detection of the EM field. Preferably, the controller is configured to move said one waveguide into alignment in dependence upon a measure of the EM field, as measured by the RAEM-FD. Preferably, the measure of the EM field comprises a reading and/or calculation of signal and/or data quality, and may in turn comprise a measure of: power; direction; spectral quality; modulation quality; Received Signal Strength Indicator (RSSI); Signal-to-Noise Ratio (SNR); throughput; latency; Bit Error Rate (BER); Packet Error Rate (PER); packet loss; and/or jitter. Preferably, the controller is configured to move the waveguide that provides the greatest signal strength or quality of the EM field into the aforementioned alignment. Preferably, the controller is further configured to identify an aligned position for the waveguide by identifying a maxima (or best quality) for the measured EM field.

Preferably, the controller is configured to operate the re-orientation mechanism so as to track the source and maintain the aligned position by maintaining a maxima (or best quality) for the measure of the EM field.

Preferably, the controller is further configured to: measure a quality of the EM field, when the re-orientation mechanism is provided in a first position; rotate the re-orientation mechanism to a second position, different to the first position; measure the quality of the EM field when the re-orientation mechanism is provided in the second position; compare said measurements for the first position and the second position; in response to determining that the measured quality is: better when in the first position compared to the second position, maintaining the re-orientation mechanism in the first position or rotating the re-orientation mechanism towards the first position; and worse when in the first position compared to the second position, maintaining the re-orientation mechanism in the second position or rotating the re-orientation mechanism away from the first position. Optionally, in response to determining that the measured quality is the same in the first position compared to the second position, maintaining the re-orientation mechanism in the first position or the second position, or rotating the re-orientation mechanism towards or away from the first or second position. Optionally, when the plurality of waveguides are different, the controller is further configured to select one of said different waveguides to arrange into alignment with the source in dependence upon the measure of the EM field. Optionally, one of the plurality of waveguides is aligned with the EM source, and a further one of the plurality of waveguides is aligned with another EM source, arranged at a different bearing from the RAEM-FD than the EM source, thereby to permit propagation of EM fields from both sources to the RAEM-FD through each respective waveguide. Optionally, the other EM source is configured to transmit an EM field that is different from the EM field from the EM source, wherein said difference is as to: frequency; data modulation mode (e.g. AM, FM, etc.); transmit power; direction of incidence upon the RAEM-FD.

Preferably, the apparatus further comprises at least one further waveguide, arranged around the RAEM-FD and configured to: impede or prevent propagation of the EM field through to the RAEM-FD; and to permit propagation of another EM field through to the RAEM-FD. Optionally, the other EM field is from the source or another source. Optionally, the other EM field is different from the EM field as to: frequency and/or polarisation. Preferably, the further waveguide is configured to impede or prevent propagation of the EM field because of the aforementioned difference/s, which may be achieved by means of an appropriate cut-off frequency and/or polariser. Preferably, the at least one further waveguide is/are arranged to be orientated in a different direction to the plurality of waveguides, and to one another where there are at least two of the further waveguides.

According to another aspect of the invention, there is provided a method of operating an apparatus for detecting an Electro-Magnetic, EM, field, said apparatus comprising a: Rydberg-Atom EM Field Detector, RAEM-FD, configured to detect an EM field from a source; plurality of waveguides for the RAEM-FD, wherein each of the plurality of waveguides is: configured to permit propagation of the EM field therethrough to the RAEM-FD; arranged around the RAEM-FD; and orientated towards a different direction; re-orientation mechanism engaged to the plurality of waveguides and configured to revolve said plurality of waveguides about the RAEM-FD; and a controller for tuning the RAEM-FD and controlling operation of the re-orientation mechanism; wherein the method comprises the steps of, by means of the controller: tuning the RAEM-FD so as to detect the EM field; retrieving a measurement of the EM field from the RAEM-FD; and actuating the re-orientation mechanism so as to move one of the plurality of waveguides into alignment between the source and the RAEM-FD.

Optionally, at least one, all, or none, of the plurality of waveguides is/are an open- or closed-ended waveguide. Preferably, the plurality of waveguides is configured to permit propagation of the EM field through the respective receiving waveguide by being suitably dimensioned relative to a wavelength of the EM field (e.g. at least one-half of said wavelength), such as to have a waveguide cut-off frequency at least equal to the given frequency, and optionally such that the propagation comprises at least a Transverse Electric (TE) mode. Preferably, the waveguide is formed of an electrically conductive material, which may be a metal (including a metal alloy), and which may in turn consist of or comprise: Aluminium; Copper; Gold; Titanium; Silver; Nickel; Platinum; Tin; and/or Zinc. Optionally, the plurality of waveguides is in the form of a/an: Multi-Parallel Plate WaveGuide (MPPWG), including formed as a non-lensing, convergent lesning or divergent lensing MPPWG; Parallel Plate WaveGuide (PPWG); Tapered Parallel Plate WaveGuide (TPPWG); or horn. Optionally, the apparatus comprises at least one EM shield extending between an adjacent pair of the plurality of waveguides , wherein the EM shield is configured to be opaque to the EM field and that is arranged to surround an outside of said pair of waveguides so as to help shield the RAEM-FD from the EM field. Preferably, any of the aforementioned features of the plurality of waveguides are, as appropriate, correspondingly present in the at least one further waveguide. According to another aspect of the invention, there is provided a radio receiver for a wireless telecommunications network comprising the apparatus as described above. Optionally, the radio receiver is for, and the wireless telecommunications is, a: wide area network; cellular network; microwave communication network; wireless local area network; and/or satellite network. The radio receiver may be a base station or an access point.

According to another aspect of the invention, there is provided a radiodetermination system comprising an apparatus as described above. Preferably, said radiodetermination system comprises a radar detection, location, and/or navigation system.

According to another aspect of the invention, there is provided a medical imaging device or system comprising an apparatus as described above. Preferably, said device or system comprises a Magnetic Resonance Imaging and/or Magnetic Resonance Spectroscopy device or system.

According to another aspect of the invention, there is provided a composition analysis instrument comprising an apparatus as described above. Preferably, said instrument is a Nuclear Magnetic Resonance (NMR) spectrometer. According to another aspect of the invention, there is provided a radio-imaging system comprising an imaging array of the apparatus described above.

The above summary is not intended to describe each illustrated embodiment or every implementation of the subject matter hereof. The invention includes any novel aspects described and/or illustrated herein. The invention also extends to methods and/or apparatus substantially as herein described and/or as illustrated with reference to the accompanying drawings. The invention is also provided as a computer program and/or a computer program product for carrying out any of the methods described herein and/or for embodying any of the apparatus features described herein, and a computer-readable medium storing thereon a program for carrying out any of the methods and/or for embodying any of the apparatus features described herein. Features described as being implemented in hardware may alternatively be implemented in software, and vice versa.

It should be understood that the individual operations used in the methods of the present teachings may be performed in any order and/or simultaneously, as long as the teaching remains operable. Furthermore, it should be understood that the apparatus and methods of the present teachings can include any number, or all, of the described embodiments, as long as the teaching remains operable.

Any apparatus feature may also be provided as a corresponding step of a method, and vice versa. As used herein, means plus function features may alternatively be expressed in terms of their corresponding structure, for example as a suitably-programmed processor.

Any feature in one aspect of the invention may be applied, in any appropriate combination, to other aspects of the invention. Any, some and/or all features in one aspect can be applied to any, some and/or all features in any other aspect, in any appropriate combination. Particular combinations of the various features described and defined in any aspects of the invention can be implemented and/or supplied and/or used independently.

As used throughout, the word 'or' can be interpreted in the exclusive and/or inclusive sense, unless otherwise specified.

The invention extends to an apparatus for detecting an Electro-Magnetic, EM, field, and a radio receiver comprising said apparatus, as described herein and/or substantially as illustrated with reference to the accompanying drawings. The present invention is now described, purely by way of example, with reference to the accompanying diagrammatic drawings, in which:

> Figure 1 is a schematic of an EM field detector comprising a plurality of waveguides;
> Figure 2 shows said EM field detector in profile;
> Figures 3a and 3b show a first example of a constituent waveguide of the EM field detector;
> Figure 4 shows a second example of the constituent waveguide; and
> Figure 5 shows an example of the EM field detector comprising a further example of the constituent waveguide.

While various embodiments are amenable to various modifications and alternative forms, specifics thereof have been shown by way of example in the drawings and will be described in detail. It should be understood, however, that the intention is not to limit the claimed inventions to the particular embodiments described. On the contrary, the intention is to cover all modifications, equivalents, and alternatives falling within the spirit and scope of the subject matter as defined by, at least, the claims.

Specific Description

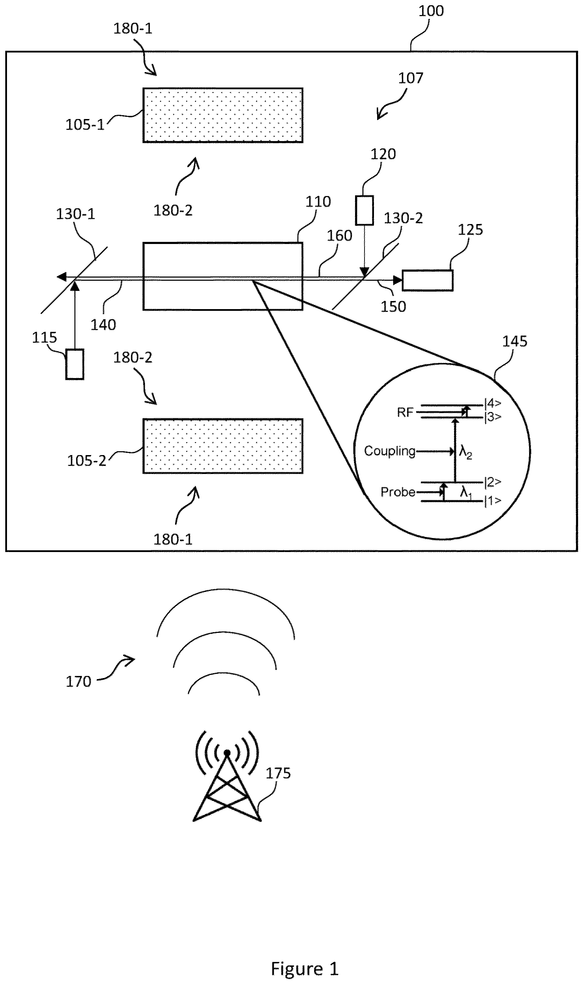

Figure 1 schematically shows an apparatus in the form of an Electro-Magnetic (EM) field detector 100 comprising a: plurality of waveguides 105; and a Rydberg-Atom EM Field Detector (herein "RAEM-FD") 107.

The RAEM-FD 107 (also known as an "atomic receiver" or a "quantum-optical receiver") in turn comprises a: Rydberg vapour cell 110; probe laser 115; coupling laser 120; photodetector 125; and a set of beamsplitters (*e.g.* dichroic mirrors) 130, comprising a first beamsplitter 130-1 and a second beamsplitter 130-2.

The Rydberg vapour cell 110 comprises a container (*e.g.* a sealed glass, ceramic or Perspex vessel) containing a low-density vaporous medium of Rydberg atoms, such as alkali metal (*e.g.* Rubidium-85 or Caesium-55) or alkaline earth metal atoms (*e.g.* Strontium-88).

A Rydberg atom is an atom with at least one electron excited to a very high principal quantum number ($n \gg 1$). Rydberg atoms experience very large dipole moments and long decay periods; these characteristics are exploited by the RAEM-FD 107 so as to receive, detect and demodulate EM fields over very large frequency ranges (compared to conventional conductive antennas), typically between so-called (as defined by the International Telecommunication Union) medium and super-high frequencies (*e.g.* between 1MHz and 30GHz), but as low as extremely low frequencies, and as high as infrared frequencies (*e.g.* between 3Hz and 1THz), in some examples. For conciseness, as used herein, the terms "radio" and "radio frequency" include, in addition to conventional radio frequencies, far infrared frequencies that are known to be detectable by a suitably configured RAEM-FD.

Each Rydberg atom has a ground state and a plurality of excited states, which may be excited (*i.e.* by absorbing a photon of sufficient energy that permits electron transition) from the ground state to an excited state. The electron then transitions by decay from the excited state to a lower excited state (*i.e.* an excited state at a lower energy level) or to the ground state, with certain transitions being unpermitted because they are dipole forbidden.

The probe laser 115 is configured and arranged to transmit - via the first beamsplitter 130-1 - a probe signal 140 through the Rydberg vapour cell 110, and thus the constituent Rydberg atoms (*e.g.* Rb-85), in which the probe signal is at a first wavelength (*e.g.* ≈780nm), $\lambda_1$, corresponding to an energy required to elevate an outer electron of the Rydberg atoms from a ground state (|1>) to a first excited state (|2>); this transition is shown in the electron transition diagram 145 in Figure 1. The probe signal that emerges from the Rydberg vapour cell 110 is referred to as the output signal 150 and is used to detect an incident EM field 170 (*e.g.* a radio-frequency signal) from an EM source 175 (*e.g.* a cellular base station, but including any radiating or reflecting body), as described below in more detail.

Simultaneously, the coupling laser 120 is configured and arranged to transmit - via the second beamsplitter 130-2 - a coupling signal 160 through the Rydberg vapour cell 110 in counter-propagation (to help reduce Doppler shifting) to, and overlapping with, the probe signal 140, in which the coupling signal 160 is at a second wavelength (*e.g.* ≈480nm), $\lambda_2$, corresponding to an energy required to elevate the outer electron of the Rydberg atoms from the first excited state (|2>) to a Rydberg state (|3>), and having greater power than the probe signal. The transition from the first excited state (|2>) to the Rydberg state (|3>) is also shown in the electron transition diagram 145 in Figure 1. Accordingly, a three-level atomic system is created (it will be appreciated by the person skilled in the art that a four-level system could correspondingly be used, for example by introducing a repump laser, with potential increases in detection sensitivity). To help (further) reduce Doppler shifting, the probe 115 and coupling 120 lasers are frequency stabilised.

In a quantum-optical and quantum-interference process known as Electromagnetically Induced Transparency (EIT), two excitation paths (*e.g.* |1> → |2> and |2>→|3>) interfere destructively and create a transparency window for the probe signal 140 operating at $\lambda_1$. For example, in an EIT ladder scheme, transition from the Rydberg state (|3>) to the ground state (|1>) is forbidden, and the ground state (11>) becomes depopulated and so fewer atoms can absorb the probe signal 140. Accordingly, the Rydberg atoms become more transparent to the probe signal 140. EIT is also realisable using other electron transition schema, such as vee and lambda.

Regardless, the photodetector 125 is arranged downstream of the Rydberg vapour cell 110 (and the second beamsplitter 130-2) in the path of the output signal 150, and is configured to measure, at least, (spectrographic) amplitude of the output signal 150. Depending on the EIT state of the Rydberg atoms, further physical effects can be exploited to detect the EM field 170 from real-time optical measurements of the output signal 150 by the photodetector 125.

Since the outer electron of the Rydberg atom is much further away from the atomic nucleus when in the Rydberg state (|3>) compared to the ground state (|1>), a high polarizability and a large dipole moment (*i.e.* through strong Rabi oscillation) is created. The outer election becomes responsive to the EM field 170 so as to cause a further transition of said electron from the Rydberg state (|3>) to an adjacent Rydberg state (|4>) when the photon energy of the EM field 170 matches the required transition energy (*e.g.* having a frequency of -3.43GHz), which causes splitting of said states into "dressed states" in a process known as Autler-Townes splitting. In turn, this state splitting causes, by EIT, the Rydberg atoms to become less transparent to the probe laser 140, causing a decrease in amplitude of the output signal 150 to an extent that is proportional to the amplitude of the incident EM field 170. The RAEM-FD 107 is operable to detect the EM field, and in particular Amplitude Modulated (AM) signals, by measuring changes in amplitude of the output signal 150. The publication C. Holloway et al., "A Multiple-Band Rydberg Atom-Based Receiver: AM/FM Stereo Reception" in IEEE Antennas and Propagation Magazine, vol. 63, no. 3, pp. 63-76, June 2021, doi: 10.1109/MAP.2020.2976914, which is herein incorporated by reference, provides details of E-field metrology using Rydberg atom-based techniques (and in particular splitting of the optical transparency region due to the presence of the incident EM field and correlation with EM field amplitude).

Correspondingly, in another example, the RAEM-FD 107 is configured to detect Frequency Modulated (FM) signals. That is, when frequency of the EM field 170 changes (or "detunes") from the frequency required for the transition between the Rydberg state (|3>) and the adjacent Rydberg state (|4>), EIT resonance again causes Autler-Townes splitting. The separation of the two peaks increases with EM field detuning. By locking the probe laser 115 and coupling laser 120 to particular frequencies, then the output signal 150 is directly correlated to the frequency modulation of the EM field, and spectrographic analysis thereof permits detection of the FM modulation. The publication D. A. Anderson et al., "An Atomic Receiver for AM and FM Radio Communication," in IEEE Transactions on Antennas and Propagation, vol. 69, no. 5, pp. 2455-2462, May 2021, doi: 10.1109/TAP.2020.2987112, which is herein incorporated by reference, provides a methodology for FM signal detection.

In yet a further example, the RAEM-FD 107 is configured to detect phase modulated EM fields, such as those of Binary Phase-Shift Keying (BPSK), Quadrature Phase-Shift Keying (QPSK), and Quadrature Amplitude Modulation (QAM) signals (used in many wireless and cellular communications protocols). In these modulation schemes, a signal is transmitted by modulating the phase of a carrier signal in the EM field 170. To detect the carrier's phase, a reference EM signal that is on-resonance with the transition to the Rydberg state (|3>) is applied to the Rydberg atoms, which acts as a local oscillator. A difference in frequencies between the carrier and reference EM signals, or the "intermediate frequency", is detected and the phase of the intermediate frequency signal corresponds directly to the relative phase between the local oscillator and the EM field 170.

In any event, the RAEM-FD 107 is configured to detect the specific frequency of the EM field 170 by selecting a particular value of $\lambda_2$ so that electrons of the Rydberg atoms are elevated to a particular Rydberg state (|3>). This particular Rydberg state (|3>) is selected so that photons at the specific frequency of the EM field 170 elevate electrons from this Rydberg state to its adjacent Rydberg state (|4>), which induces a change in the EIT that is then detected by the photodetector 125 from characteristics of the output signal 150.

Regardless of the modulation scheme used (amplitude, frequency and/or phase), to improve directional sensitivity, the RAEM-FD 107 is coupled to the plurality of waveguides 105 to form the EM field detector 100. In the example of Figure 1, the plurality of waveguides 105 consists of a first waveguide 105-1 and a second waveguide 105-2.

Both the first and second waveguides are arranged so as to guide an inbound EM field (such as EM field 170) towards the vapour cell 110 from an outwardly facing (relative to the vapour cell) input end 180-1 through to an inwardly 180-2 facing output end. Each of the plurality of waveguides 105 are fixed relative to the RAEM-FD 107, are both in alignment with the vapour cell 110 and therebetween (and therefore all fall within the same plane), and are disposed on opposite sides of the vapour cell. That is, the first 105-1 and second 105-2 waveguides are offset by 180°, and therefore with their respective input ends facing opposite bearings. For example, where the first waveguide 105-1 is orientated North, the second waveguide 105-2 is orientated South.

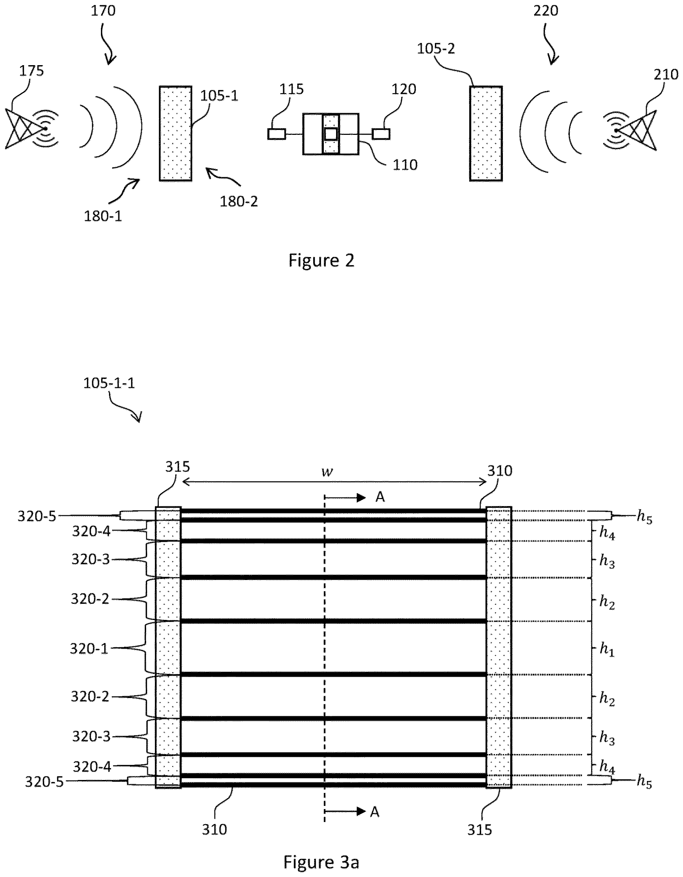

As best shown in Figure 2, when the first waveguide 105-1 is arranged in alignment between the EM source 170 and the vapour cell, the EM field is guided by said waveguide towards the vapour cell. Simultaneously, when the second waveguide 105-2 is arranged between a further EM source 210 transmitting a further EM field 220 and the vapour cell, the further EM field 220 is guided to the vapour cell. In this way, the EM field detector is capable of receiving (and optionally detecting) the EM fields 17, 220 from each different source 175, 210 via the augmentation of each respective waveguide 105. In this way, the multi-directional sensitivity of the EM field detector is improved.

In one example, the EM field detector 100 is deployed as a receiver in a radio transceiver relay system for, and disposed in-between, the sources 175, 210. By virtue of the inherent sensitivity of the RAEM-FD, as augmented by each waveguide, and with the addition of dual-direction waveguides respectively orientated towards each source, a sensitivity improved relay receiver is provided.

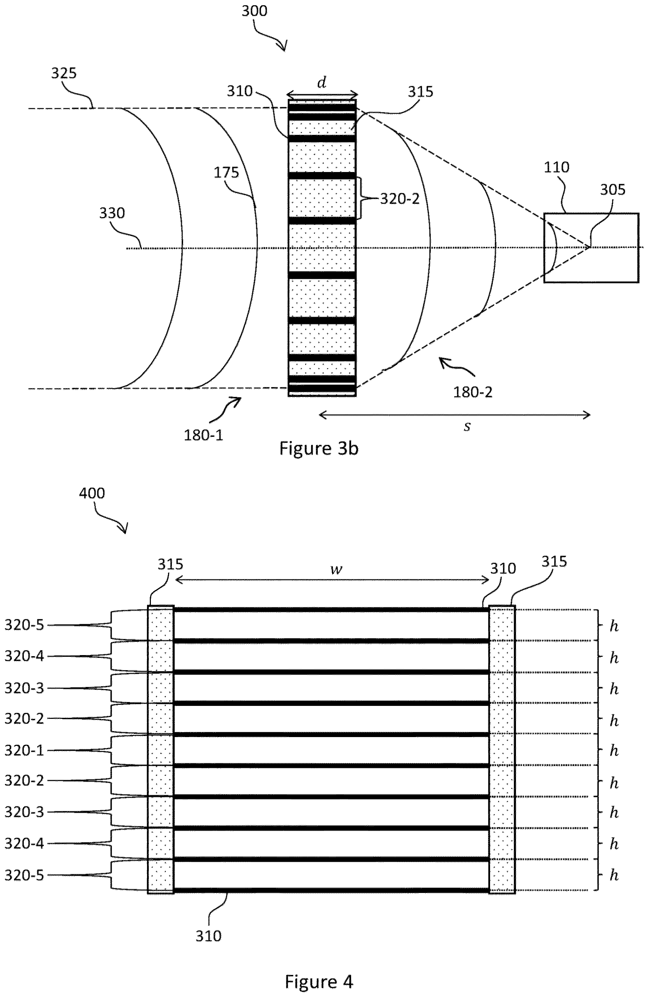

Figures 3a and 3b show, in detail (and with features of the wider EM field detector 100 omitted for conciseness), a first example of a constituent one of the plurality of waveguides 105 (*i.e.* the first 105-1 and/or second 105-2 waveguide), in which said waveguide is in the form of a Multi-Plate WaveGuide (MPWG) that is configured as a static stepped-index convergent waveguide lens (herein simply "static lens") 300 suitable for focussing the EM field 170 (and further EM field 210) onto the RAEM-FD 107, and specifically the vapour cell 110.

Figures 3a and 3b show the static lens 300 in a front elevation and a cross-section along line A-A, respectively. Figure 3b further schematically shows propagation of the EM field 170 through the static lens 300 to a focal line 305 (from the input end 180-1 to the output end 180-2).

The static lens 300 comprises a plurality of (exemplarily in Figures 3a and 3b, ten) stacked, and fully overlapping, plates 310 that are each mutually parallel and that are fixed at opposing terminal ends to a pair of endplates 315, thereby forming a ladder-like structure. Each plate 315 is formed of an electric conductor, and in particular a metal (*e.g.* comprising or consisting of Aluminium, Copper, Gold, Nickel, Silver, Tungsten, Zinc, Iron, and/or Titanium, *etc.*).

Each adjacent pair of plates 310, along with the endplates 315, define an open-ended and air-filled rectangular waveguide 320, and the static lens 300 comprises a plurality of (exemplarily in Figures 3a and 3b, nine) waveguides 320, including a/an: single innermost waveguide 320-1, formed by a pair of the innermost (or centremost) plates; pair of second waveguides 320-2, stacked adjacent both sides of the innermost waveguide 320-1, wherein each of the second waveguides 320-2 share a constituent plate of the first waveguide 320-1; and successive third 320-3, fourth 320-4 and outermost 320-5 pairs of waveguides that further nest outwardly from the innermost 320-1 and second 320-2 waveguides in a corresponding manner.

The pair of plates 310 forming a given waveguide 320 are separated by an inter-pair separation height, $h_i$, where $i$ denotes an index of a given waveguide 320, such that $i$ = 1, 2, 3, 4 and 5 for the innermost waveguide 320-1, and the pair of second 320-2, third 320-3, fourth 320-4, and outermost 320-5 waveguides, respectively.

The value of $h_i$ dictates a local phase refractive index, $n_i$, of the corresponding $i^{th}$ waveguide/s, according to *Equation 1* below:

$$n_i = \sqrt{1 - \left(\frac{c}{2h_i f}\right)^2}$$

in which, c is the speed of light in a vacuum, and $f$ is a frequency of the incident EM field 170 (or the further EM field 220) to which the RAEM-FD 107 is tuned to detect. The refractive index of the media contained within the waveguides 320 has been taken to be 1 (as is substantially appropriate in the present example of the air-filled waveguides 320 in a like standard atmospheric environment) and is therefore not shown as a term.

To configure the static lens 300 as a convergent lens, successive adjacent waveguides 320, from the innermost waveguide 320-1 to the outermost waveguides 320-5, are arranged such that the respective value of $h_i$ monotonically decreases, and the values of $n_i$ therefore correspondingly decrease as governed by *Equation 1*; that is, $h_1 > h_2 > h_3 > h_4 > h_5$, and $n_1 > n_2 > n_3 > n_4 > n_5$.

Values of $h_i$ are selected to achieve a desired refractive index for the value of $f$ (*i.e.* of the EM field 170 and/or EM field 220), and in turn a desired overall convergent lensing effect achieving a given focal length, $s$. For example, values of $h_i$ are selected to form a stepped-index lens having a profile approximating a parabola or mimicking a section of a hyperbola, ellipse, or circle.

Each waveguide 320 has a width, $w$, which is the lateral extent of each constituent pair of plates 310 between each endplate 315. In the examples of Figures 3a and 3b, $w$ is equal for all waveguides 320. Ideally, $w$ is substantially equal to, or greater than, the wavelength of the EM field to be detected, with larger values of $w$ increasing the aperture of the static lens 300, thereby increasing an energy collection area. Furthermore, the static lens 300 is dimensioned such that the values of $h_i$ and w provide waveguides 320 having a waveguide cutoff frequency no less than $f$.

Perpendicularly to $w$, and in the plane of each plate 310, each plate has a depth, $d$, which is - in this example - equal for all plates (and thus also equal for all waveguides 320). The value of $d$ is approximately at least equal to the corresponding wavelength for $f$, thereby to create a guided mode (as opposed to inducing diffractive effects) for, at least, the constituent E-field of the EM field 170 (or EM field 220). To help reduce scattering, each plate 310 is dimensioned to have a minimal relative thickness (*e.g.* less than 2mm or so).

The static lens 300 is separated from the vapour cell 110 by the focal length, $s$, of said lens for $f$, such that the focal line 305 (*i.e.* extending, at $s$, parallel to w) of the static lens 300 lies within, and ideally at a centre of, the vapour cell 110.

Figure 3b illustrates propagation of the EM field 170 through the static lens 300, represented schematically by rays 325 (shown with long-dash lines). The EM field 170 propagating through the static lens 300 effectively bends towards the region having the greatest refractive index, *i.e.* $n_1$, and specifically towards a plane 330 (shown in profile with dotted lines) bisecting - parallel to the constituent plates 310 of - the innermost waveguide 320-1 .

The static lens 300 causes the EM field 170 to converge to the focal line 305 within the plane 330. The innermost waveguide 320-1, and therefore the plane 330, is arranged in alignment with the vapour cell 110, such that said plane bisects said cell. All else being equal, *s* is dictated by the selected values of $h_i$, and by *f*. The static lens 300 and a centre of the vapour cell 110 are separated by the ensuing value of *s*, thereby to arrange the vapour cell 110 at the focal line 305 for the EM field 170. In this way, the static lens 300 effectively focuses the EM field 170 (or, at least, a component having a frequency of *f*) onto the Rydberg vapour cell 110, thereby increasing sensitivity of the RAEM-FD 107 when the waveguide is orientated between the inbound EM field 170 and the vapour cell.

For example, dimensions of the innermost waveguide 320-1 are: $h_1$ = 29mm (and successively decreasing by 2mm with each successive waveguide, *i.e.* such that $h_5$ = 21mm); *w* = 800mm; and *d* = 36mm. At such dimensions, the static lens 300 is therefore suitable for focussing the EM field 170 in which *f* = 10.1 GHz (which, for the RAEM-FD 107, corresponds with the transition $^{61}D_{5/2}$ to $^{60}F_{7/2}$ of Rubidium-85); in this case, *s* = 180mm. Where the EM field 170 has a beam diameter of 300mm, a depth of field of approximately 90mm results.

Advantageously, the static lens 300 also has the effect of helping selectively filter-out interference at or below the corresponding waveguide cutoff frequency.

In one example, the first 150-1 and second 150-2 waveguides are both in the form of the static lens 300, and are in turn either identical or differ, for example as to form (*e.g.* distribution of plates, thereby affecting lensing effects, and in particular focal length) and/or dimensions (*e.g.* overall, and/or relative inter-plate height variance).

Figure 4 shows, in a front elevation, a second example of a waveguide that forms at least one of the plurality of waveguides 105 (*e.g.* the first 105-1 and/or second 105-2 waveguides), which is in the form of a MPWG formed as a non-lensing waveguide 400, in which the static lens 300 is modified such that each of the waveguides 320 all have the same value of $h_i$. Accordingly, like features of the non-lensing waveguide 400 to those of the static lens 300 are described below with reference to, and as shown in, Figures 4 using identical reference numerals.

The non-lensing waveguide 400 is centrally aligned with the vapour cell 110, and the waveguides 320 are dimensioned with a value of $h_i$ so as to permit guided propagation of the EM field 170 (specifically, at least, the constituent E-field) towards the vapour cell 110 (*i.e.* such that the waveguide cutoff frequency is less than *f*). The non-lensing waveguide 400 confines propagation of the EM-field 170 thereby helping to constrain power of the propagating EM field, and thus help increase sensitivity of the RAEM-FD 107.

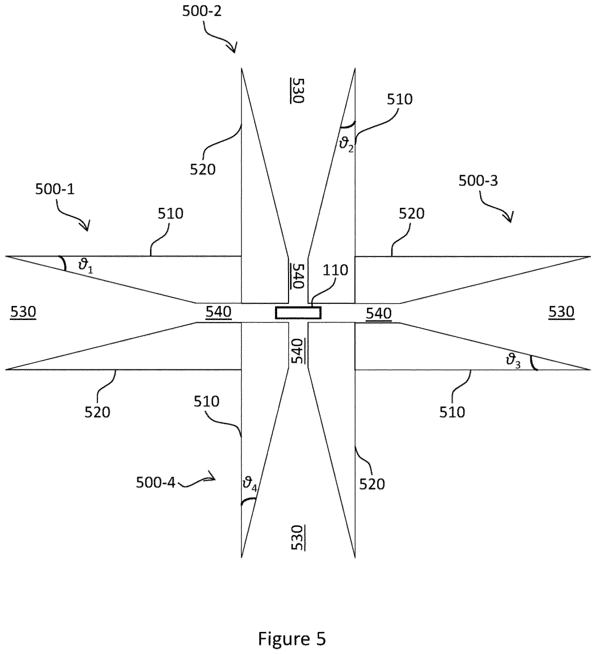

In another example, Figure 5 shows the plurality of waveguides 105 consisting of four waveguides, arranged as a cross, that are each in the form of a Tapered Plate WaveGuide (TPWG) 500, and that namely consist of a: first 500-1 TPWG; second 500-2 TPWG; third 500-3 TPWG; and fourth 500-4 TPWG.

Each TPWG 500 comprises a respective first plate 510 and a second plate 520, both formed of an electrical conductor (*e.g.* a metal), arranged to provide, therebetween, a volume forming a gradual flared mouth 530 (*i.e.* an input end 180-1) and a straight throat 540 (*i.e.* an output end 180-2). The first 510 and second 520 plates are separated such that the throat 540 provides a waveguide cutoff frequency below the frequency of the EM field 170 (and/or the further EM field 220).

In the example of Figure 5, each of the TPWGs 500 are arranged in the same plane and with each respective mouth orientated in a different direction, but with each respective throat facing the vapour cell 110. The first TPWG 500-1 is arranged such that the corresponding first 510 and second 520 plates, proximate to the corresponding throat 540, abuts the second plate 520 and first 510 plate of the second 500-2 and fourth 500-4 TPWGs, respectively. Correspondingly, the third TPWG 500-3 is arranged such that the corresponding second 520 and first 510 plates, proximate to the corresponding throat 540, abuts the first plate 510 and second plate 520 of the second 500-2 and fourth 500-4 TPWGs, respectively. Each successively numbered TPWG 500 is effectively rotated by 90° (*i.e.* the second TPWG 500-2, and specifically the corresponding mouth 530, is rotated by 90° from the corresponding mouth 530 of the first TPWG 500-1, *etc.*).

The vapour cell 110 is arranged within a cavity formed at the convergence of the four TPWGs 500, and proximate to, and mutually aligned with, each throat 540.

As with the other specific examples of the plurality of waveguides 105 described above, the plurality of TPWGs increase an effective aperture size of the EM field detector 100, thereby to increase inbound power collection, and subsequently increase power concentration of the EM field at the corresponding throat, and together provide improved multi-directional sensitivity for the singular RAEM-FD.

As will be appreciated, the aperture extent of each mouth 530, taper angle of the mouth ($\vartheta$), separation distance between the first 510 and second 520 plates, and smoothness of the transition between the mouth and throat affect gain and propagation mode through each given TPWG 500, and are therefore to be selected to ensure effective propagation of the EM field 170 through the TPWG. Whilst all four of the TPWGs 500 are shown to be identical in Figure 5, in an alternative, two, three, or all, of the TPWGs are different (at least as to the aforementioned parameters), thereby providing TPWGs that differ both as to orientation and function. In a more specific example, where the first TPWG 500-1 is configured for optimal propagation of a given frequency of the EM field, the (opposing) fourth TPWG 500-4 is instead configured for optimal propagation of a lower frequency than said given frequency, which may help counteract a Doppler effect (*e.g.* red-shifting at the fourth TPWG 500-4 relative to the first TPWG 500-1).

To remain effective as a waveguide or lens at low frequencies, the various waveguides 105 described above become impractically large. However, when the RAEM-FD 107 is configured and operated to be ultra-wideband (*e.g.* with appropriate control of lasers 115, 120, and/or a local oscillator, if provided), the waveguides 105 may remain small and permit increased sensitivity at high frequencies detectable by the RAEM-FD, whilst simultaneously causing negligible detriment to detection of low frequencies by the same RAEM-FD.

Alternatives and Modifications

Additionally or alternatively, the static lens 300 is formed as a tuneable stepped-index convergent waveguide lens (or a "*tuneable lens*" or "*trans-tuneable lens*"), for example as described in co-pending European Patent Application Number 24179958.4 (filed 4 June 2024) in the name of *British Telecommunications public limited company*, and specifically as described, at least, on pp. 13-17, the contents of which are herein incorporated by reference. In this way, the focal line 305 of the tuneable lens is adjustable so as to coincide with the vapour cell 110 (*e.g.* in response to changes in frequency of the EM field 170).

Additionally or alternatively, the static lens 300, is instead configured as a divergent lens by instead monotonically increasing $h_i$ from the innermost waveguide 320-1 to the outermost waveguides 320-5 (and $n_i$ correspondingly). Such a divergent lens may instead be used to help filter interference (at a frequency *f*) from reaching the vapour cell 100.

Additionally or alternatively, the static lens 300 is formed as a translatable stepped-index convergent waveguide lens (or a "*translatable lens*"), for example, as also described in co-pending European Patent Application Number 24179958.4 (filed 4 June 2024) in the name of *British Telecommunications public limited company*, and specifically as described, at least, on pp. 15-16, the contents of which are herein incorporated by reference. In this way, the focal line 305 of the translatable lens is adjustable so as to coincide with the vapour cell 110 (*e.g.* in response to changes in frequency in the EM field 170). For example, an extendable linear actuator is additionally provided and configured to permit an increase and decrease in separation between the static lens 300 and the vapour cell 110.

Any of the plurality of waveguides 105 are available to be identical to, or different from, one another, and at least as to type or form of waveguide (*e.g.* MPWG, TPWG, horn, etc.) and/or dimensions (including dimensions affecting cutoff frequency, separation distance from the vapour cell and/or focal length, where applicable).

It will be appreciated that adjacent pairs of the waveguides 105 are available to be angularly offset by any extent (*e.g.* by 45°, 90° or 180° along the same plane).

In an alternative, at least one, or all, or the plurality of waveguides 105 is/are in the form of a horn, and more specifically of a sectoral, pyramidal, spiral, conical, exponential, dual-mode conical, diagonal, ridged, septum, aperture-limited, corrugated, or open boundary quad-ridged kind.

In an alternative, the plurality of waveguides 105, or additionally the RAEM-FD 107 (and therefore effectively the entire EM field detector 100) is mounted on a re-orientation mechanism (not shown) so as to permit group re-orientation of the plurality of waveguides 105 (*e.g.* towards the EM source/s 175, 210). For example, the plurality of waveguides 105 (or, additionally, the RAEM-FD 107) is mounted on a carousel that is configured to orbit about the vapour cell 110, thereby to permit selection of a specific one of the plurality of waveguides 105 to be orientated towards a specific EM source, and additionally subsequent tracking thereof.

In yet another example, the plurality of waveguides 105 are mounted on independent re-orientation mechanisms, therefore to permit independent re-orientation of each of the plurality of waveguides 105. As a result, the EM field detector 100 is operable independently to track two or more inbound EM fields. Where the waveguides 105 have different frequency-response characteristics and where the EM fields are of different frequencies, the waveguide 105 that best suits each the EM field may be selected for orientation theretoward. To achieve such a construction, the re-orientation mechanisms are, for example, in the form of stacked and aligned rotary mechanisms providing concentric orbits for the plurality of waveguides 105.

To aid automatic and optimal orientation of the plurality of waveguides 105, the re-orientation mechanism/s comprise/s a controller (not shown) configured to manoeuvre the plurality of waveguides 105 so as to maximise waveguiding efficacy, as sensed by a measure of signal strength of the EM field, as in turn detected by the RAEM-FD 107. For example, the controller is configured to execute a direction-finding algorithm based on comparing measured signal strength (as detected by RAEM-FD) with bearing of the re-orientation mechanism/s.

In yet another alternative, the, or each, re-orientation mechanism is configured simultaneously to reorientate a corresponding at least one of the plurality of waveguides about two axes, thereby permitting spherical orbit about the vapour cell 110. To achieve such, the re-orientation mechanism is/are, for example, in the form of a two-axis gimbal.

In yet another alternative, voids between the (input ends 180-1) of the plurality of waveguides 105 are instead obstructed by an EM shield, extending between adjacent waveguides 105 and enshrouding the vapour cell 110, and in which the EM shield is configured to be substantially opaque to the EM field (*e.g.* by appropriate composition and structure), thereby to obfuscate a region surrounding the waveguide/s 105 (without obstructing a path into the waveguide/s 105). In this way, the EM field detector may improve directional sensing all the more by blocking stray EM fields that may otherwise be received by the vapour cell and bypass the waveguides.

It will be appreciated that the EM field detector 100 is available to incorporate alternative forms of the RAEM-FD 107 that are apparent to the person skilled in the art, especially having alternative quantum (*e.g.* as to the selected Rydberg atom and electron transitions, and the operation of the lasers 115, 120) and optical (*e.g.* absent the first beamsplitter 130-1, such that the probe laser 115 is directly aligned with the Rydberg vapour cell 110) configurations.

In one embodiment, the system and/or its components or subsystems can include computing devices, microprocessors, modules and other computer or computing devices, which can be any programmable device that accepts digital data as input, is configured to process the input according to instructions or algorithms, and provides results as outputs. In one embodiment, computing and other such devices discussed herein can be, comprise, contain or be coupled to a Central Processing Unit (CPU) configured to carry out the instructions of a computer program. Computing and other such devices discussed herein are therefore configured to perform basic arithmetical, logical, and input/output operations.

Computing and other devices discussed herein can include memory. Memory can comprise volatile or non-volatile memory as required by the coupled computing device or processor to not only provide space to execute the instructions or algorithms, but to provide the space to store the instructions themselves. In one embodiment, volatile memory can include Random Access Memory (RAM), Dynamic Random Access Memory (DRAM), or Static Random Access Memory (SRAM), for example. In one embodiment, non-volatile memory can include read-only memory, flash memory, ferroelectric RAM, hard disk, floppy disk, magnetic tape, or optical disc storage, for example. The foregoing lists in no way limit the type of memory that can be used, as these embodiments are given only by way of example and are not intended to limit the scope of the disclosure.

In one embodiment, the system or components thereof can comprise or include various modules or engines, each of which is constructed, programmed, configured, or otherwise adapted to autonomously carry out a function or set of functions. The term "engine" as used herein is defined as a real-world device, component, or arrangement of components implemented using hardware, such as by an application specific integrated circuit (ASIC) or field programmable gate array (FPGA), for example, or as a combination of hardware and software, such as by a microprocessor system and a set of program instructions that adapt the engine to implement the particular functionality, which (while being executed) transform the microprocessor system into a special-purpose device. An engine can also be implemented as a combination of the two, with certain functions facilitated by hardware alone, and other functions facilitated by a combination of hardware and software. In certain implementations, at least a portion, and in some cases, all, of an engine can be executed on the processor(s) of one or more computing platforms that are made up of hardware (*e.g.*, one or more processors, data storage devices such as memory or drive storage, input/output facilities such as network interface devices, video devices, keyboard, mouse or touchscreen devices, etc.) that execute an operating system, system programs, and application programs, while also implementing the engine using multitasking, multithreading, distributed (e.g., cluster, peer-peer, cloud, etc.) processing where appropriate, or other such techniques. Accordingly, each engine can be realized in a variety of physically realizable configurations, and should generally not be limited to any particular implementation exemplified herein, unless such limitations are expressly called out. In addition, an engine can itself be composed of more than one sub-engines, each of which can be regarded as an engine in its own right. Moreover, in the embodiments described herein, each of the various engines corresponds to a defined autonomous functionality; however, it should be understood that in other contemplated embodiments, each functionality can be distributed to more than one engine. Likewise, in other contemplated embodiments, multiple defined functionalities may be implemented by a single engine that performs those multiple functions, possibly alongside other functions, or distributed differently among a set of engines than specifically illustrated in the examples herein.

Various embodiments of systems, devices, and methods have been described herein. These embodiments are given only by way of example and are not intended to limit the scope of the claimed inventions. It should be appreciated, moreover, that the various features of the embodiments that have been described may be combined in various ways to produce numerous additional embodiments. Moreover, while various materials, dimensions, shapes, configurations and locations, etc. have been described for use with disclosed embodiments, others besides those disclosed may be utilized without exceeding the scope of the claimed inventions.

Persons of ordinary skill in the relevant arts will recognise that embodiments may comprise fewer features than illustrated in any individual embodiment described above. The embodiments described herein are not meant to be an exhaustive presentation of the ways in which the various features may be combined. Accordingly, the embodiments are not mutually exclusive combinations of features; rather, embodiments can comprise a combination of different individual features selected from different individual embodiments, as understood by persons of ordinary skill in the art. Moreover, elements described with respect to one embodiment can be implemented in other embodiments even when not described in such embodiments unless otherwise noted. Although a dependent claim may refer in the claims to a specific combination with one or more other claims, other embodiments can also include a combination of the dependent claim with the subject matter of each other dependent claim or a combination of one or more features with other dependent or independent claims. Such combinations are proposed herein unless it is stated that a specific combination is not intended. Furthermore, it is intended also to include features of a claim in any other independent claim even if this claim is not directly made dependent to the independent claim.

Moreover, reference in the specification to "one embodiment," "an embodiment," or "some embodiments" means that a particular feature, structure, or characteristic, described in connection with the embodiment, is included in at least one embodiment of the teaching. The appearances of the phrase "in one embodiment" in various places in the specification are not necessarily all referring to the same embodiment.

Any incorporation by reference of documents above is limited such that no subject matter is incorporated that is contrary to the explicit disclosure herein. Any incorporation by reference of documents above is further limited such that no claims included in the documents are incorporated by reference herein. Any incorporation by reference of documents above is yet further limited such that any definitions provided in the documents are not incorporated by reference herein unless expressly included herein.

Each feature disclosed herein, and (where appropriate) as part of the claims and drawings may be provided independently or in any appropriate combination.

Any reference numerals appearing in the claims are for illustration only and shall not limit the scope of the claims.

**Claims**

1. An apparatus for detecting an Electro-Magnetic, EM, field, said apparatus comprising a:

   Rydberg-Atom EM Field Detector, RAEM-FD, configured to detect an EM field from a source; and
   plurality of waveguides for the RAEM-FD, wherein each of the plurality of waveguides is:

   configured to permit propagation of the EM field therethrough to the RAEM-FD;
   arranged around the RAEM-FD; and

orientated towards a different direction.

2. An apparatus according to Claim 1, wherein at least two, none, or all, of the plurality of waveguides are different.

3. An apparatus according to Claim 1 or 2, wherein at least three, or all, of the plurality of waveguides are arranged in the same plane.

4. An apparatus according to any preceding claim, wherein the plurality of waveguides comprises at least one of a:

   Parallel-Plate WaveGuide, PPWG;
   Multi-Plate WaveGuide, MPWG;
   Tapered Parallel-Plate WaveGuide, TPPWG;
   horn; and/or
   lens.

5. An apparatus according to any preceding claim, further comprising a re-orientation mechanism engaged to the plurality of waveguides and configured to revolve said plurality of waveguides about the RAEM-FD.

6. An apparatus according to Claim 5, further comprising a controller configured to:

   tune the RAEM-FD so as to detect the EM field;
   measure the EM field, as detected by the RAEM-FD; and
   control operation of the re-orientation mechanism so as to move one of the plurality of waveguides into alignment between the source and the RAEM-FD.

7. An apparatus according to Claim 5 or 6, wherein the controller is further configured to:

   measure a quality of the EM field, when the re-orientation mechanism is provided in a first position;
   rotate the re-orientation mechanism to a second position, different to the first position;
   measure the quality of the EM field when the re-orientation mechanism is provided in the second position;
   compare said measurements for the first position and the second position;
   in response to determining that the measured quality is:

   better when in the first position compared to the second position, maintaining the re-orientation mechanism in the first position or rotating the re-orientation mechanism towards the first position; and

worse when in the first position compared to the second position, maintaining the re-orientation mechanism in the second position or rotating the re-orientation mechanism away from the first position.

8. An apparatus according to any preceding claim, further comprising at least one further waveguide, arranged around the RAEM-FD and configured to: impede or prevent propagation of the EM field through to the RAEM-FD; and to permit propagation of another EM field through to the RAEM-FD.

9. A method of operating an apparatus for detecting an Electro-Magnetic, EM, field, said apparatus comprising a:

> Rydberg-Atom EM Field Detector, RAEM-FD, configured to detect an EM field from a source; plurality of waveguides for the RAEM-FD, wherein each of the plurality of waveguides is:
>
>> configured to permit propagation of the EM field therethrough to the RAEM-FD; arranged around the RAEM-FD; and orientated towards a different direction;
>
> re-orientation mechanism engaged to the plurality of waveguides and configured to revolve said plurality of waveguides about the RAEM-FD; and
> controller for tuning the RAEM-FD and controlling operation of the re-orientation mechanism;

wherein the method comprises the steps of, by means of the controller:

> tuning the RAEM-FD so as to detect the EM field; retrieving a measurement of the EM field from the RAEM-FD; and
> actuating the re-orientation mechanism so as to move one of the plurality of waveguides into alignment between the source and the RAEM-FD.

Figure 1

Figure 2

Figure 3a

Figure 3b

Figure 4

Figure 5

Europäisches
Patentamt
European
Patent Office
Office européen
des brevets

# EUROPEAN SEARCH REPORT

**Application Number**

EP 24 19 7328

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/283581 A1 (STANFORD RES INST INT [US]) 12 January 2023 (2023-01-12) | 1-4 | INV. G01R29/08 |
| A | * paragraphs [0090] - [0116]; claims 1-30; figures 8-17 * | 5-9 | |
| | ----- | | |
| X | CN 115 032 464 A (PEOPLE'S LIBERATION ARMY NATIONAL UNIVERSITY OF DEFENSE TECHNOLOGY) 9 September 2022 (2022-09-09) | 1-4 | |
| A | * paragraphs [0045] - [0108]; claims 1-12; figures 1-8 * | 5-9 | |
| | ----- | | |
| X | US 11 977 107 B1 (YU SU-PENG [CA] ET AL) 7 May 2024 (2024-05-07) | 1-4 | |
| A | * columns 24-28; claims 1-30; figures 14A-15F * | 5-9 | |
| | ----- | | |
| A | CN 115 184 693 A (PEOPLE'S LIBERATION ARMY NATIONAL UNIVERSITY OF DEFENSE TECHNOLOGY) 14 October 2022 (2022-10-14) * paragraphs [0003], [0014] - [0032]; claims 1-7; figures 1-5 * | 4 | TECHNICAL FIELDS SEARCHED (IPC) G01R H04B |
| | ----- | | |

The present search report has been drawn up for all claims

| Place of search | Date of completion of the search | Examiner |
|---|---|---|
| Munich | 22 January 2025 | Bilzer, Claus |

EPO FORM 1503 03.82 (P04C01)

## ANNEX TO THE EUROPEAN SEARCH REPORT
## ON EUROPEAN PATENT APPLICATION NO.

EP 24 19 7328

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2025

| Patent document cited in search report | | Publication date | Patent family member(s) | | Publication date |
|---|---|---|---|---|---|
| WO 2023283581 | A1 | 12-01-2023 | DE 112022002980 | T5 | 28-03-2024 |
| | | | US 2024310422 | A1 | 19-09-2024 |
| | | | WO 2023283581 | A1 | 12-01-2023 |
| CN 115032464 | A | 09-09-2022 | NONE | | |
| US 11977107 | B1 | 07-05-2024 | NONE | | |
| CN 115184693 | A | 14-10-2022 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 24179958

**Non-patent literature cited in the description**

- **C. HOLLOWAY et al.** A Multiple-Band Rydberg Atom-Based Receiver: AM/FM Stereo Reception. *IEEE Antennas and Propagation Magazine*, June 2021, vol. 63 (3), 63-76

- **D. A. ANDERSON et al.** An Atomic Receiver for AM and FM Radio Communication,. *IEEE Transactions on Antennas and Propagation*, May 2021, vol. 69 (5), 2455-2462